# EUROPÄISCHE PATENTANMELDUNG

(11) **EP 2 642 541 A1**
(43) Veröffentlichungstag der Anmeldung: **25.09.2013**
(21) Anmeldenummer: 12160690.9
(22) Anmeldetag: 22.03.2012
(51) Int. Cl.: H01L 33/54, H01L 33/58, G02B 3/02

(54) **Leuchtdiode**

(71) Anmelder: Odelo GmbH, 71409 Schwaikheim (DE)
(72) Erfinder: Kunze, Jochen, 47441 Moers (DE)
(74) Vertreter: Benninger, Johannes

(57) **Zusammenfassung**

Es wird eine Leuchtdiode (01) mit:
- mindestens einem LED-Chip (02),
- einer auf dem mindestens einen LED-Chip (02) aufstehenden optischen Achse (03),
- einer Lichtabstrahlrichtung entlang der optischen Achse (03) weg von dem mindestens einen LED-Chip (02), und
- einem den LED-Chip (02) wenigstens zum Teil umhüllenden Lichtleitkörper (04), der eine geschlossene Mantelfläche (05) sowie diese von der Oberfläche (06) des LED-Chips (02) entlang der optischen Achse (03) in Richtung der Lichtabstrahlrichtung entfernt abschließend zwei konzentrische Lichtaustrittsflächen (07, 08) aufweist, eine erste Lichtaustrittsfläche (07) und eine diese umgebende, zweite Lichtaustrittsfläche (08),
beschrieben. Von dem LED-Chip (02) abgestrahltes Licht trifft zum Austritt aus dem Lichtleitkörper (04) entweder direkt auf die erste Lichtaustrittsfläche (07), oder wird unter Totalreflexion zunächst an der Mantelfläche (05) im Lichtleitkörper (04) umgelenkt, bevor es dann auf die zweite Lichtaustrittsfläche (08) trifft. Höchstens zwei in unterschiedlichen Winkellagen um die optische Achse (03) liegende und die optische Achse (03) einschließende Querschnitte weisen eine identische geometrische Formgebung (09, 10, 15, 17, 19, 21, 22) der inneren und/oder der äußeren Lichtaustrittsflächen (07, 08) auf.

## Beschreibung

Die Erfindung betrifft eine Leuchtdiode gemäß dem Oberbegriff des Anspruchs 1.

Als Lichtquellen kommen unter anderem wegen ihres hohen Wirkungsgrads bei der Umwandlung elektrischen Stroms in Licht und ihres damit einhergehend geringen Stromverbrauchs vermehrt Leuchtdioden zum Einsatz.

Eine Leuchtdiode besteht zumindest aus wenigstens einem Lichtemittierende-Diode-Halbleiter-Chip, kurz LED-Chip, sowie aus mindestens einem Kontaktmittel zur elektrischen Kontaktierung des LED-Chips. Üblicherweise verfügt jede Leuchtdiode über einen Bonddraht je LED-Chip, welcher je einen LED-Chip elektrisch kontaktiert. Dieser Bonddraht bildet ein erstes Kontaktmittel für den LED-Chip der Leuchtdiode. Der Bonddraht kann mit einem ersten elektrischen Anschluss verbunden sein, welcher zur elektrischen Kontaktierung der Leuchtdiode beispielsweise mit einer ersten Leiterbahn eines Leuchtmittelträgers vorgesehen sein kann. Ein zweites Kontaktmittel für den LED-Chip der Leuchtdiode bildet der LED-Chip selbst. Zur elektrischen Kontaktierung kann der LED-Chip mit einem zweiten elektrischen Anschluss verbunden sein, welcher zur elektrischen Kontaktierung der Leuchtdiode beispielsweise mit einer zweiten Leiterbahn eines Leuchtmittelträgers vorgesehen sein kann.

Die Leuchtdiode kann darüber hinaus einen den LED-Chip unmittelbar umgebenden Primärreflektor aufweisen. Dieser Primärreflektor kann beispielsweise durch Wandungen einer den LED-Chip umgebenden Ausnehmung und/oder durch einen Napf gebildet sein, in dem der LED-Chip angeordnet ist. Der Napf kann mit dem erwähnten zweiten Anschluss verbunden sein, diesen bilden oder umfassen oder von diesem umfasst werden.

Bei speziellen Ausführungen von Leuchtdioden können einzelne oder alle Kontaktmittel selbst die elektrischen Anschlüsse bilden, wie nachfolgend zu den verschiedenen Kontaktierungsmöglichkeiten von Leuchtdioden ausgeführt.

Bekannt sind Leuchtdioden zur Durchsteckmontage (THT; Through Hole Technology), oberflächenmontierbare (SMD; Surface Mounted Device) Leuchtdioden und Leuchtdioden, bei denen der LED-Chip in Nacktmontagetechnik (COB; Chip On Board) direkt auf den Leuchtmittelträger gebondet wird.

THT-Leuchtdioden sind der gängig bekannte Typ Leuchtdioden. Sie werden auch als bedrahtete Leuchtdioden bezeichnet, da sie aus einer zumindest in einer gewünschten Abstrahlrichtung transparenten Kapselung, z.B. in Form einer Umspritzung oder eines Vergusses bestehen, welche einen den LED-Chip mit einem ersten elektrischen Anschluss, beispielsweise in Form eines Anodenanschlusses verbindenden Bonddraht und den mit einem zweiten elektrischen Anschluss, beispielsweise in Form eines Kathodenanschlusses, verbundenen LED-Chip einschließt. Aus der Kapselung ragen nur die auch als Beinchen bezeichneten Drähte des ersten elektrischen Anschlusses und des zweiten elektrischen Anschlusses als die Anoden- und Kathodenanschlüsse der THT-Leuchtdiode. Der beispielsweise als Kathodenanschluss ausgeführte zweite elektrische Anschluss kann hierbei mit einem oben erwähnten Napf versehen sein, in dem der LED-Chip angeordnet ist. Der Bonddraht führt vom beispielsweise als Anodenanschluss ausgeführten ersten Anschluss von außerhalb des Napfs kommend zum LED-Chip.

SMD-Leuchtdioden bestehen aus einem Leadframe mit wenigstens einer Bestückungsfläche für mindestens einen LED-Chip sowie elektrischen Anschlussflächen. Das Leadframe ist von einem Kunststoffkörper mit zumindest einer die wenigstens eine Bestückungsfläche freihaltenden Ausnehmung teilweise umspritzt. Die elektrischen Anschlussflächen des Leadframes sind hierbei als die elektrischen Anschlüsse der SMD-Leuchtdiode zur späteren Oberflächenmontage ebenfalls freigehalten. Der mindestens eine LED-Chip ist am Grund der zumindest einen zur wenigstens einen Bestückungsfläche reichenden Ausnehmung angeordnet und elektrisch kontaktiert. Dabei ist der LED-Chip auf einer mit wenigstens einer ersten elektrischen Anschlussfläche verbundenen ersten Partie des Leadframes angeordnet. Ein Bonddraht verbindet den LED-Chip mit einer zweiten Partie des Leadframes, die wiederum mit wenigstens einer zweiten elektrischen Anschlussfläche verbunden ist. Die an ihrem Grund zur Bestückungsfläche reichende Ausnehmung kann reflektorartig ausgestaltet sein. Dabei bilden die Wandungen der Ausnehmung den oben erwähnten Primärreflektor. Hierbei können die Wandungen reflektierend beschichtet sein.

COB-Leuchtdioden bestehen aus einem direkt auf einem Leuchtmittelträger anzuordnenden, ungehäusten LED-Chip und einem Bonddraht. Die Rückseite des LED-Chips bildet dabei den ersten elektrischen Anschluss der COB-Leuchtdiode. Zur elektrischen Kontaktierung wird der LED-Chip auf seiner Rückseite direkt mit einer ersten Leiterbahn eines Leuchtmittelträgers z.B. durch Löten oder Schweißen elektrisch verbunden. Der den zweiten elektrischen Anschluss der COB-Leuchtdiode bildende Bonddraht wird mit einer zweiten Leiterbahn des Leuchtmittelträgers ebenfalls z.B. durch Löten oder Schweißen elektrisch verbunden.

Der Vollständigkeit halber sei ergänzend erwähnt, dass auch andere Kontaktierungen wie z.B. der so genannte Flip-Chip-Aufbau möglich sind, bei dem die Kontaktmittel des LED-Chips direkt mit einem kontaktierten Substrat verbunden sind. In diesen Fällen wird kein Bonddraht verwendet.

Zumindest bei den THT- und SMD-Leuchtdioden ist bekannt, den LED-Chip mittels einer Kapselung umfassend einen diesen wenigstens zum Teil umhüllenden, transparenten, beispielsweise angespritzten Lichtleitkörper einzuschließen.

Herausragende Eigenschaften von Leuchtdioden im Vergleich zu anderen, herkömmlichen Lichtquellen sind neben deren wesentlich längerer Lebensdauer und deren wesentlich höherer Lichtausbeute bei gleicher Leistungsaufnahme deren deutlich kompakteren Abmessungen.

Dies ermöglicht es, in Verbindung mit Leuchtdioden als Lichtquellen Leuchtmittel herzustellen, die an jede erdenkliche Einbausituation angepasst sein können. Dabei können eine oder mehrere, einzeln oder gruppenweise, beispielsweise in einem Strang zu mehreren angeordnete Leuchtdioden als mindestens eine Lichtquelle eines Leuchtmittels vorgesehen sein.

Eine typische Anpassung an die Einbausituation betrifft die Abmessungen und die Form sowie beispielsweise äußere Gestalt einer Leuchte oder einer Leuchtenkammer, für welche ein Leuchtmittel vorgesehen ist.

Eine weitere typische Anpassung an die Einbausituation betrifft den zur Verfügung stehenden Bauraum. Dabei wird ein möglichst geringer Bauraumbedarf angestrebt, um durch Verwendung eines Leuchtmittels mit geringem Bauraumbedarf auch für eine mit einem solchen Leuchtmittel versehene Leuchte insgesamt kompaktere Abmessungen erhalten zu können, wodurch weiter reichende Vorteile erzielt werden können. Beispielsweise steht bei einer als Heckleuchte ausgeführten Kraftfahrzeugleuchte mit geringem Bauraumbedarf mehr Platz für den Kofferraum eines Kraftfahrzeugs zur Verfügung. Gleichzeitig können Material und Gewicht gespart werden, wodurch beispielsweise Energieeinsparungen, wie etwa Verbrauchseinsparungen von Treibstoff oder eine geringere Belastung eines Stromspeichers einhergehend mit einer Verringerung der Umweltbelastung sowohl bei der Herstellung, als auch im Betrieb eines Kraftfahrzeugs erreicht werden können.

Neben der Anpassung an die Einbausituation müssen Leuchtmittel sehr hohe Qualitätsanforderungen erfüllen. So werden beispielsweise bereits geringe Abweichungen von einem homogenen Eindruck des Erscheinungsbilds sowohl im ausgeschalteten Zustand des Leuchtmittels, dem so genannten Kaltzustand, als auch im so genannten Warmzustand bei eingeschaltetem Leuchtmittel, als qualitätsmindernd angesehen.

Beispiele für Abweichungen von einem homogenen Eindruck des Erscheinungsbilds sind allem voran eine ungleichmäßige Ausleuchtung einer Leuchtfläche im Warmzustand, beispielsweise einer reflektierenden Fläche eines Reflektors und/oder einer Lichtauskoppelfläche eines Lichtleiters. Aber auch ein dunkel erscheinendes Lampenloch in einem Reflektor im Kaltzustand und/oder ein möglicherweise blendender, direkter Blick des Betrachters auf die Lichtquelle eines Leuchtmittels im Warmzustand können Abweichungen von einem homogenen Eindruck des Erscheinungsbilds darstellen.

Ein als Lichtleiter bezeichnetes totalreflektierendes (TIR; Total Internal Reflection), lichtleitendes Element mit einem Lichteinkoppelbereich und einem Lichtauskoppelbereich ermöglicht beispielsweise ein vollständiges Verbergen der einen oder mehreren Lichtquellen, indem es das von einer verborgen angeordneten Lichtquelle in es am Lichteinkoppelbereich eingekoppelte Licht in Richtung Auskoppelbereich leitet und dort wieder auskoppelt. Dadurch kann ein direkter Blick auf eine Lichtquelle verhindert werden.

Um einen homogenen Eindruck des Erscheinungsbilds einer durch die reflektierende Fläche eines Reflektors gebildeten Leuchtfläche im Warmzustand zu erhalten, ist es wünschenswert, dass die mindestens eine einen solchen Reflektor ausleuchtende Lichtquelle eines Leuchtmittels eine der Geometrie des Reflektors hinsichtlich Konzentration sowie Streuung des Lichts bezüglich der Lichtabstrahlrichtung angepasste Lichtabstrahlcharakteristik aufweist, welche den Reflektor für das Auge des Betrachters homogen ausleuchtet.

Ein eine reflektierende Fläche umfassender Reflektor kann dabei Teil eines Leuchtmittels sein.

Beispielsweise bei Kraftfahrzeuganwendungen vermehrt zum Einsatz kommende ausgeprägt rechteckige oder elliptische Reflektoren, bei denen eine Ausdehnung die andere deutlich überragt, können mit den gegenwärtig als Lichtquellen zur Verfügung stehenden Leuchtdioden nur annähernd homogen ausgeleuchtet werden, indem Leuchtdioden vorgesehen werden, deren über den Umfang verteilt gleichmäßige radiale Lichtabstrahlcharakteristik an jeder Stelle über die reflektierende Fläche hinaus reicht. Dadurch kann zwar die reflektierende Fläche vollständig ausgeleuchtet werden, jedoch geht der darüber hinaus reichende Teil des von der Leuchtdiode ausgestrahlten Lichts verloren und steht dadurch nicht mehr zur lichttechnischen Verwendung zur Verfügung. Dies wirkt sich nachteilig auf die optische Güte aus, welche vereinfacht das Verhältnis des von einem Leuchtmittel oder einer Leuchte zu einem bestimmten Zweck abgegebenen und damit lichttechnisch genutzten Lichts zum von der mindestens einen hierfür vorgesehenen Lichtquelle abgestrahlten Licht widerspiegelt.

Bei der Einstrahlung von Licht einer oder mehrerer Leuchtdioden in einen Lichtleiter verhält es sich ebenso. Ein Lichtleiter, in den Licht mindestens einer Lichtquelle an mindestens einer Lichteinkoppelfläche wenigstens eines Lichteinkoppelbereichs ein- und an mindestens einer von der Lichteinkoppelfläche verschiedenen Lichtauskoppelfläche zumindest eines Lichtauskoppelbereichs wieder ausgekoppelt wird, kann dabei Teil eines Leuchtmittels sein.

Der Lichtleiter kann beispielsweise stabförmig als so genannter Stablichtleiter und/oder flächig als so genannter Flächenlichtleiter ausgebildet sein, mit einer auf seiner beispielsweise normal zur Hauptabstrahlrichtung einer Kraftfahrzeugleuchte orientierten Vorderseite angeordneten Lichtauskoppelfläche.

Um einen homogenen Eindruck des Erscheinungsbilds einer durch die Lichtauskoppelfläche eines Lichtleiters gebildeten Leuchtfläche im Warmzustand zu erhalten, ist es wünschenswert, dass die mindestens eine ihr Licht in einen solchen Lichtleiter einstrahlende Lichtquelle eine derart angepasste Lichtabstrahlcharakteristik aufweist, dass die Lichtaustrittsfläche des Lichtleiters für das Auge des Betrachters homogen ausgeleuchtet erscheint. Dies kann durch eine Anpassung der Lichtabstrahlcharakteristik an die Geometrie einer Lichteinkoppelfläche des Lichtleiters hinsichtlich Konzentration sowie Streuung des Lichts beispielsweise in Bezug auf die Lichtabstrahlrichtung erfolgen. Das ausgekoppelte Licht kann dabei direkt, ohne einen Reflektor in der gewünschten Richtung abgestrahlt werden, oder indirekt, indem es in einen Reflektor eingestrahlt wird, der es dann in die gewünschte Richtung reflektiert.

Nachteilig bei einem Lichtleiter ist, dass dieser bei einem gekrümmten Verlauf und/oder bei einem nur geringen zur Verfügung stehenden Bauraum leicht eine inhomogene Ausleuchtung durch das in ihn eingekoppelte Licht erfährt, was wiederum als qualitätsmindernd empfunden wird. Zur Erfüllung der hohen Qualitätsanforderungen wird deshalb eine möglichst homogene Leuchtdichteverteilung entlang des Lichtleiters angestrebt.

Darüber hinaus weist auch ein mindestens eine Lichteinkoppelfläche umfassender Lichteinkoppelbereich eines Lichtleiters häufig eine inhomogene Ausleuchtung und damit ein nicht zufrieden stellendes Erscheinungsbild auf.

Dies ist dadurch beding, dass punktförmige Lichtquellen, wie diese beispielsweise Leuchtdioden darstellen, eine bestimmte Wegstrecke zur für ein homogenes Erscheinungsbild notwendigen Lichtausbreitung benötigen.

Wegen der oft engen Bauraumsituation ist eine Wegstrecke oftmals nicht gegeben, die zur einer optimalen Lichtausbreitung notwendig wäre. So zeigt der Einkoppelbereich oft störende Spots und ungewollte Flammbereiche.

Um dieses Problem zu umgehen ist bekannt, den Einkoppelbereich hinter einer Abdeckblende zu kaschieren. Dies ist allerdings nur unter bestimmten Voraussetzungen der Gestaltung einer mit einem solchen Lichtleiter versehenen Leuchte, insbesondere Kraftfahrzeugleuchte, möglich. Darüber hinaus steht das hinter der Abdeckblende ungewollt bereits im Lichteinkoppelbereich wieder aus dem Lichtleiter austretende Licht nicht mehr zur weiteren lichttechnischen Verwendung zur Verfügung und stellt eine erhebliche Einschränkung der optischen Güte dar.

Beispielsweise bei Kraftfahrzeuganwendungen vermehrt zum Einsatz kommende Lichtleiter mit einem von der kreisrunden Querschnittsform quer zur Richtung der auch als Propagation bezeichneten Lichtausbreitung im Lichtleiter abweichenden Form, beispielsweise ausgeprägt rechteckig oder elliptisch, wobei eine Ausdehnung die andere deutlich überragt, können mit den gegenwärtig als Lichtquellen zur Verfügung stehenden Leuchtdioden nicht homogen ausgeleuchtet werden, ohne Einschränkungen der optischen Güte in Kauf nehmen zu müssen.

Durch DE 103 40 039 B4 ist eine Leuchtdiode mit einem LED-Chip und einem diesen wenigstens zum Teil umhüllenden, angespritzten Lichtleitkörper bekannt. Eine mittig senkrecht auf der Oberfläche des LED-Chips aufstehende Achse definiert eine Lichtabstrahlrichtung der Leuchtdiode. Der Lichtleitkörper weist eine geschlossene Mantelfläche sowie diese von der Oberfläche des LED-Chips entlang der Lichtabstrahlrichtung entfernt abschließend zwei konzentrische Lichtaustrittsflächen auf, eine erste, innere Lichtaustrittsfläche und eine diese umgebende, zweite äußere Lichtaustrittsfläche. Von dem LED-Chip abgestrahltes Licht trifft entweder direkt auf die innere Lichtaustrittsfläche und tritt gegebenenfalls unter Brechung aus dem Lichtleitkörper aus, oder wird unter Totalreflexion zunächst an der Mantelfläche im Lichtleitkörper umgelenkt und tritt dann durch die äußere Lichtaustrittsfläche gegebenenfalls unter Brechung aus dem Lichtleitkörper aus. In einem Querschnitt parallel zur Lichtabstrahlrichtung weisen die innere, als auch die äußere Lichtabstrahlfläche entweder jeweils eine zur Achse der Lichtabstrahlrichtung symmetrische geometrische Formgebung, oder eine asymmetrische Formgebung auf. In unterschiedlichen Winkellagen um die Achse der Lichtabstrahlrichtung gesehen weisen im Fall symmetrischer Querschnitte alle Querschnitte oder im Falle asymmetrischer Querschnitte die Hälfte aller Querschnitte jeweils identische geometrische Formgebungen sowohl der inneren, als auch der äußeren Lichtabstrahlfläche auf.

Nachteilig an dieser Leuchtdiode ist eine sehr hohe Konzentration des Lichts in Richtung parallel zur Lichtabstrahlrichtung. Hierdurch streut das Licht im Inneren eines Lichtleiters sehr gering und eine homogene Auskopplung aus dem Lichtleiter an dafür üblichen Auskoppelstellen ist nur schwer zu verwirklichen. Mit einer etwas breiteren radialen Lichtabstrahlcharakteristik kann diesem Effekt entgegengewirkt werden, beispielsweise mit einem Abstrahlwinkel von 20-40°, jedoch wird das Licht nicht nur horizontal entlang der Lichtleiters gestreut sondern auch in üblicherweise der vertikalen Richtung, in der nicht ausgekoppelt wird. Die Totalreflexionen der Lichtbündel, die vertikal entlanglaufen werden also über die Länge des Lichtleiters absorbiert oder in eine ungewünschte Richtung ausgekoppelt. Ebenso verhält es sich für Reflektoranwendungen wegen der starken Fokussierung auf einen Bereich im Reflektor. Hierdurch wird außerdem keine homogene Abstrahlung erhalten.

Zusammengefasst ist diese Leuchtdiode für Anwendungen, bei denen in einen Lichtleiter oder einen Reflektor mit einem von einer kreisrunden Form abweichenden Querschnitt, beispielsweise mit ausgeprägt elliptischem oder rechteckigem Querschnitt Licht hocheffizient eingekoppelt bzw. eingestrahlt werden muss, ungeeignet.

Durch DE 10 2004 042 125 B4 ist eine Leuchtdiode mit einem LED-Chip und einer Kapselung bestehend aus einem diesen wenigstens zum Teil umhüllenden, angespritzten Lichtleitkörper bekannt. Eine mittig senkrecht auf der Oberfläche des LED-Chips aufstehende Achse definiert eine Lichtabstrahlrichtung der Leuchtdiode. Der Lichtleitkörper weist eine geschlossene Mantelfläche sowie diese von der Oberfläche des LED-Chips entlang der Lichtabstrahlrichtung entfernt abschließend zwei konzentrische Lichtaustrittsflächen auf, eine erste, innere Lichtaustrittsfläche und eine diese umgebende, zweite äußere Lichtaustrittsfläche. Von dem LED-Chip abgestrahltes Licht trifft entweder direkt auf die innere Lichtaustrittsfläche und tritt gegebenenfalls unter Brechung aus dem Lichtleitkörper aus, oder wird unter Totalreflexion zunächst an der Mantelfläche im Lichtleitkörper umgelenkt und tritt dann durch die äußere Lichtaustrittsfläche gegebenenfalls unter Brechung aus dem Lichtleitkörper aus. Die äußere Lichtaustrittsfläche ist mit einer Vielzahl von Kissenoptiken versehen, welche der Erzeugung einer definierten Lichtabstrahlcharakteristik dienen. In einem Querschnitt parallel zur Lichtabstrahlrichtung weisen die innere, als auch die äußere Lichtabstrahlfläche jeweils eine zur Achse der Lichtabstrahlrichtung symmetrische geometrische Formgebung auf. In unterschiedlichen Winkellagen um die Achse der Lichtabstrahlrichtung gesehen weisen eine Vielzahl aller Querschnitte jeweils identische Formgebungen sowohl der inneren, als auch der äußeren Lichtabstrahlfläche auf.

Nachteilig an dieser Leuchtdiode ist, dass die Zykluszeit in der Produktion relativ lange ist, da ein großer optischer Körper hergestellt werden muss. Dies gilt sowohl für aufgesteckte Optiken als auch für eine mittels Spritzgussverfahren in einem Schuss hergestellte Leuchtdiode. Auch die formgebenden Teile für die Kissenoptiken sind aufgrund der geringen optischen Toleranzen teuer in der Herstellung.

Eine Aufgabe der Erfindung ist die Entwicklung einer Leuchtdiode, welche unter Einhaltung einer hohen optischen Güte als Lichtquelle zur homogenen Ausleuchtung einer reflektierenden Fläche eines von der kreisrunden Form abweichenden Reflektors und/oder zur Einstrahlung in einen Lichtleiter geeignet und darüber hinaus einfach und kostengünstig herstellbar ist.

Die Aufgabe wird gelöst mit den Merkmalen des unabhängigen Anspruchs.

Die Erfindung sieht demnach zur Lösung der Aufgabe unter gleichzeitiger Behebung der erwähnten Nachteile des Standes der Technik eine Leuchtdiode vor.

Die Leuchtdiode kann zur Verwendung in einem Leuchtmittel, beispielsweise einem Leuchtmittel für eine Kraftfahrzeugleuchte geeignet sein.

Die Leuchtdiode kann zur Einstrahlung des von ihr im eingeschalteten Zustand ausgestrahlten Lichts in einen Lichtleiter vorgesehen sein. Alternativ oder zusätzlich kann die Leuchtdiode zur Ausleuchtung eines Reflektors vorgesehen sein. Der Lichtleiter und/oder der Reflektor können Bestandteil eines Leuchtmittels sein, welches mindestens eine Leuchtdiode als Lichtquelle umfasst. Beispielsweise kann die Leuchtdiode Bestandteil eines Leuchtmittels umfassend mindestens die Leuchtdiode als wenigstens eine Lichtquelle und zumindest einen Lichtleiter sein. Auch ist denkbar, dass ein solches Leuchtmittel anstelle oder zusätzlich zu einem Lichtleiter einen oder mehrere Reflektoren aufweist, welche vermittels mindestens einer Leuchtdiode als Lichtquelle ausgeleuchtet werden. Der Lichtleiter und/oder der Reflektor können dabei eine ausgeprägt elliptische oder rechteckige Lichteinkoppel- bzw. auszuleuchtende Reflektorfläche haben.

Die Leuchtdiode umfasst mindestens einen LED-Chip. Darüber hinaus umfasst die Leuchtdiode einen den mindestens einen LED-Chip wenigstens zum Teil umhüllenden Lichtleitkörper. Der Lichtleitkörper kann vorzugsweise angespritzt sein. Der Lichtleitkörper kann eine den LED-Chip nebst Kontaktmitteln, beispielsweise einen Bonddraht schützende Kapselung bilden, eine solche Kapselung umfassen oder Teil einer solchen Kapselung sein.

Eine auf der Oberfläche des mindestens einen LED-Chips aufstehende optische Achse definiert eine Lichtabstrahlrichtung der Leuchtdiode. Die Lichtabstrahlrichtung ist dabei weg vom LED-Chip gerichtet. Die Lichtabstrahlrichtung verläuft abhängig vom Grad einer wie nachfolgend erläutert hergestellten Bündelung oder Streuung mehr oder weniger parallel zur optischen Achse in Abhängigkeit von der Winkellage um die optische Achse herum. Hierdurch ergibt sich für die Lichtabstrahlrichtung eine Schaar von von der Oberfläche des LED-Chips ausgehend von diesem weg gerichteten Lichtstrahlen, welche alle innerhalb eines gedachten Kegels mit abhängig von ihrer Winkellage um die optische Achse herum unterschiedlichen zwischen ihnen und der optischen Achse eingeschlossenen Öffnungswinkeln. Die optische Achse kann beispielsweise mittig, vorzugsweise senkrecht auf dem mindestens einen LED-Chip aufstehen.

Der Lichtleitkörper weist eine geschlossene Mantelfläche auf. Der Leichtleitkörper weist darüber hinaus zwei konzentrische Lichtaustrittsflächen auf, welche die Mantelfläche von der Oberfläche des LED-Chips entlang der optischen Achse in Lichtabstrahlrichtung entfernt abschließen.

Bei den konzentrischen Lichtaustrittsflächen handelt es sich um eine erste, innere Lichtaustrittsfläche und eine diese umgebende, zweite, äußere Lichtaustrittsfläche.

Von dem LED-Chip abgestrahltes Licht trifft entweder direkt auf die erste, innere Lichtaustrittsfläche, durch welche es dann aus dem Lichtleitkörper austritt, oder wird unter Totalreflexion zunächst an der Mantelfläche im Lichtleitkörper umgelenkt, bevor es dann auf die zweite, äußere Lichtaustrittsfläche trifft, durch welche es dann aus dem Lichtleitkörper austritt.

Der Austritt aus dem Lichtleitkörper durch die erste, innere Lichtaustrittsfläche oder durch die zweite, äußere Lichtaustrittsfläche hindurch erfolgt gegebenenfalls unter Brechung beim Übergang vom Material des Lichtleitkörpers zum diesen umgebenden Medium, typischerweise Luft, parallel und/oder unter einem Winkel zur optischen Achse in Richtung der Lichtabstrahlrichtung.

Die erste, innere Lichtaustrittsfläche und/oder die zweite, äußere Lichtaustrittsfläche weist bzw. weisen in höchstens zwei die optische Achse einschließenden Querschnitten in unterschiedlichen Winkellagen um die optische Achse herum jeweils identische Formgebungen auf.

Jeder die optische Achse einschließende Querschnitt ist durch eine Ebene gebildet, in welcher die Kontur der ersten, inneren Lichtaustrittsfläche und der zweiten, äußeren Lichtaustrittsfläche in dem Querschnitt jeweils eine in dieser Ebene verlaufende Kurve darstellt. Die Kurve der ersten, inneren Lichtaustrittsfläche und die Kurve der zweiten, äußeren Lichtaustrittsfläche können dabei stetig ineinander übergehen oder eine Sprungstelle aufweisen. Die Kurve der ersten, inneren Lichtaustrittsfläche und die Kurve der zweiten, äußeren Lichtaustrittsfläche bilden jeweils eine Formgebung der ersten, inneren Lichtaustrittsfläche und der zweiten, äußeren Lichtaustrittsfläche in dem die optische Achse einschließenden Querschnitt.

Durch die in höchstens zwei die optische Achse einschließenden Querschnitten identische Formgebung der ersten, inneren Lichtaustrittsfläche und/oder der zweiten, äußeren Lichtaustrittsfläche wird die zuvor erwähnte Bündelung oder Streuung abhängig von der Winkellage um die optische Achse herum hergestellt. So lässt sich in der Draufsicht auf den Lichtleitkörper entlang der optischen Achse entgegen der Lichtabstrahlrichtung beispielsweise ausgehend von einer gedachten, beispielsweise in einem im Urzeigersinn drehenden kartesischen Koordinatensystem auf der Ordinatenachse angeordneten 0° Winkellage ausgehend in einer Winkellage eine Lichtabstrahlrichtung parallel zur optischen Achse verwirklichen, wohingegen in einer hiervon verschiedenen, anderen Winkellage ein zwischen der optischen Achse und der Lichtabstrahlrichtung eingeschlossener Winkel größer 0°, beispielsweise zwischen 20° und 40° verwirklicht werden kann. Hierdurch wird ein Lichtleitkörper erhalten, mit dem eine Leuchtdiode mit einer ausgeprägt elliptischen oder rechteckigen Lichtabstrahlcharakteristik, bei der eine erste Ausdehnung eine zweite Ausdehnung deutlich übersteigt, verwirklicht werden kann.

Die Einschränkung auf höchstens zwei die optische Achse einschließende Querschnitte mit gleicher Formgebung der ersten, inneren Lichtaustrittsfläche und/oder der zweiten, äußeren Lichtaustrittsfläche erlaubt die Herstellung eines symmetrischen Lichtleitkörpers mit Paaren von identischer Formgebungen der ersten, inneren Lichtaustrittsfläche und/oder der zweiten, äußeren Lichtaustrittsfläche in beispielsweise jeweils um 180° um die Achse der Lichtabstrahlrichtung verdrehten Winkellagen.

In mindestens einem die optische Achse einschließenden Querschnitt können vorzugsweise sowohl die erste, innere, als auch die zweite, äußere Lichtabstrahlfläche jeweils eine zur auf dem LED-Chip aufstehenden optischen Achse bevorzugt symmetrische geometrische Formgebung aufweisen, wobei höchstens zwei die optische Achse einschließende Querschnitte in unterschiedlichen Winkellagen um die optische Achse herum identische Formgebungen aufweisen.

Grundsätzlich ist jedoch auch denkbar, dass kein die optische Achse einschließender Querschnitt in einer Winkellage um die optische Achse herum einem Querschnitt in einer anderen Winkellage gleicht. Dies kann beispielsweise erreicht werden, indem über einen Umlauf der Winkellagen um die optische Achse herum nicht nur ein Parameter der ersten, inneren Lichtabstrahlfläche und/oder der zweiten, äußeren Lichtabstrahlfläche variiert wird, wie beispielsweise der Krümmung der Formgebung im jeweiligen Querschnitt, sondern zusätzlich ein zweiter Parameter variiert wird, wie beispielsweise ein radialer Abstand des Krümmungsmittelpunkts zur Achse der Lichtabstrahlrichtung. Durch eine solche, zumindest zwei Parameter umfassende Variation kann in jedem die optische Achse einschließenden Querschnitt in einer Winkellage um die optische Achse herum eine von einem Querschnitt in beliebiger anderer Winkellage verschiedene Formgebung erzielt werden.

Alternativ oder zusätzlich kann die innere oder die äußere Lichtabstrahlfläche in mehreren, die optische Achse einschließenden Querschnitten über einen verschiedene Winkellagen um die optische Achse herum einschließenden Winkellagenbereich hinweg konstante Formgebungen aufweisen, während die verbleibende Lichtabstrahlfläche über den Winkellagenbereich hinweg jeweils unterschiedliche Formgebungen aufweist, so dass wiederum gilt, dass höchstens zwei in unterschiedlichen Winkellagen um die optische Achse liegende und die optische Achse einschließende Querschnitte identische Formgebungen aufweisen. Darüber hinaus lässt sich durch unabhängige Variation der Formgebung der ersten, inneren Lichtabstrahlfläche und der zweiten, äußeren Lichtabstrahlfläche das zuvor genannte Kriterium von die optische Achse einschließenden Querschnitten mit in jeder Winkellage um die optische Achse herum unterschiedlichen Formgebungen erfüllen.

Alternativ können sowohl die erste, innere, als auch die zweite, äußere Lichtabstrahlfläche jeweils unterschiedliche Formgebungen aufweisen, so dass auch hier gilt, dass höchstens zwei in unterschiedlichen Winkellagen um die optische Achse herum angeordnete und die optische Achse einschließende Querschnitte identische Formgebungen aufweisen.

Damit weisen in beliebigen Winkellagen um die optische Achse herum gesehen höchstens zwei die optische Achse einschließende Querschnitte jeweils identische geometrische Formgebungen sowohl der inneren, als auch der äußeren Lichtabstrahlfläche auf.

Eine vorteilhafte Ausgestaltung der Erfindung sieht vor, dass die innere Lichtaustrittsfläche zumindest abschnittsweise eine geometrische Formgebung entsprechend einer konvexen Wölbung aufweist.

Eine alternative oder zusätzliche vorteilhafte Ausgestaltung der Erfindung sieht vor, dass die äußere Lichtaustrittsfläche zumindest abschnittsweise eine geometrische Formgebung mit einer in einem die optische Achse einschließenden Querschnitt betrachtet zur inneren Lichtaustrittsfläche hin abfallenden Wölbung aufweist.

Eine besonders vorteilhafte Ausgestaltung der Erfindung sieht vor, dass die äußere Lichtaustrittsfläche alternativ oder zusätzlich zumindest abschnittsweise eine geometrische Formgebung mit einer in einem die optische Achse einschließenden Querschnitt betrachtet weg von der inneren Lichtaustrittsfläche zur Mantelfläche hin abfallenden Wölbung aufweisen kann.

Ebenfalls ist denkbar, dass die äußere Lichtaustrittsfläche zumindest abschnittsweise eine geometrische Formgebung entsprechend einer in einem in einem die optische Achse einschließenden Querschnitt betrachtet normal zur Achse der Lichtabstrahlrichtung liegenden Geraden aufweist.

Eine andere vorteilhafte Ausgestaltung der Erfindung sieht vor, dass in Richtung der Lichtabstrahlrichtung entlang der optischen Achse gesehen die äußere Lichtaustrittsfläche vorzugsweise die innere Lichtaustrittsfläche überragt.

In einer Projektion auf eine Fläche normal zur optischen Achse oder in einer Betrachtung in Richtung entgegen der Lichtabstrahlrichtung entlang der optischen Achse gesehen können beide Lichtaustrittsflächen eine elliptische Außenkontur aufweisen.

Die Lichtabstrahlcharakteristik der Leuchtdiode ist rechteckig abstrahlend, die in einer ersten, beispielsweise horizontalen Richtung in einem gewünschten Winkelbereicht streut und in einer zweiten, beispielsweise vertikalen Richtung wenig Lichtleistung oder nur in einem geringen Winkelbereich emittiert.

Die Leuchtdiode weist hierdurch eine elliptische, rechteckige oder eine Mischung dieser beiden Lichtabstrahlcharakteristiken auf. Diese kann speziell für ausgeprägt rechteckige oder elliptisch geformte Lichtleitereinkopplungen sowie ausgeprägt rechteckig oder elliptischgeformte Reflektoren, wobei eine Ausdehnung die andere deutlich überragt, beispielsweise in Kraftfahrzeugleuchten angewendet werden.

Sich hieraus zusätzlich zu einer Behebung der Nachteile des Standes der Technik und neben einer vollständigen Erfüllung der der Erfindung zu Grunde liegenden Aufgabe ergebende Vorteile sind unter Anderem, dass die Leuchtdiode geeignet ist, einen Lichtleiter beispielsweise mit einem von der kreisrunden Form abweichenden Querschnitt normal zur Lichtausbreitung im Lichtleiter derart auszuleuchten, dass ein homogener Eindruck seiner gesamten Lichtaustrittsfläche erhalten wird. Hierbei ist die Leuchtdiode gegenüber dem Lichtleiter so angeordnet, dass eine durch die erste Richtung aufgespannte Fläche, innerhalb der eine Streuung des ausgestrahlten Lichts erfolgt, sich zwischen Lichtauskoppelfläche und einer dieser gegenüber liegenden Lichtumlenkfläche erstreckt, wohingegen die Bündelung in einer sich parallel zur Lichtauskoppelfläche erstreckenden, durch die zweite Richtung aufgespannten Fläche erfolgt. Hierdurch kann der gestreute Anteil bereits nahe dem Lichteinkoppelbereich liegende Partien des Lichtleiters so ausleuchten, dass ein homogener Eindruck der Lichtauskoppelfläche dieser Partien des Lichtleiters erhalten wird. Der gebündelte Anteil propagiert weiter im Lichtleiter und sorgt für eine Ausleuchtung von dem Lichteinkoppelbereich entfernten Partien des Lichtleiters, so dass ebenfalls ein homogener Eindruck der Lichtauskoppelfläche dieser Partien des Lichtleiters erhalten wird. Die spezielle Ausgestaltung der Leuchtdiode einhergehend mit einer entsprechend an die Lichtabstrahlcharakteristik angepassten Anordnung zur Ausleuchtung eines Reflektors oder zur Einstrahlung in einen Lichtleiter stellt sicher, dass kein oder nur sehr wenig Licht einer lichttechnischen Verwendung verloren geht. Hierdurch wird eine sehr hohe optische Güte erhalten.

Vorteile der Erfindung gegenüber dem Stand der Technik sind unter Anderem der Verzicht auf kleine und damit schwierig unter hohem Kostenaufwand herzustellender optischer Strukturen auf der inneren bzw. äußeren Lichtaustrittsfläche sowie ein geringes Volumen des Lichtleitkörpers, wodurch kurze Zykluszeiten bei der Herstellung erreicht werden können. Hierdurch wird eine kostengünstige Herstellung ermöglicht.

Weitere sich durch eine Verbesserung der optischen Güte ergebende Vorteile gegenüber dem Stand der Technik sind ein homogenes Erscheinungsbild sowohl eines Lichtleiters, als auch eines Reflektors, in welchen Licht einer solchen Leuchtdiode eingekoppelt bzw. eingestrahlt wird aus verschiedenen Betrachtungsrichtungen frei von durch das menschliche Auge wahrnehmbaren, unterschiedlichen Helligkeiten unter gleichzeitiger Erfüllung der beispielsweise durch gesetzliche Vorschriften vorgegebenen und die Lichtverteilung in einer oder mehreren Vorzugsrichtungen sowie die Leuchtdichte in der mindestens einen Vorzugsrichtung umfassenden lichttechnischen Anforderungen bei gleichzeitig geringer erforderlicher in den Lichtleiter bzw. den Reflektor einzukoppelnder bzw. einzustrahlender Strahlungsleistung bzw. geringem erforderlichem in den Lichtleiter einzukoppelndem bzw. in den Reflektor einzustrahlendem Lichtstrom. Hierdurch wird ein besonders wirtschaftlicher und effektiver Umgang mit der zur Verfügung stehenden Energie erzielt. Bei Kraftfahrzeuganwendungen ergibt sich dadurch eine besonders günstige Auslegung und Dimensionierung des Bordnetzes einhergehend mit einer verbesserten Wirtschaftlichkeit und Gewichtseinsparungen.

Die Erfindung wird nachfolgend anhand von in den Zeichnungen dargestellter Ausführungsbeispiele näher erläutert. Darin bezeichnen gleiche Bezugszeichen gleiche oder gleich wirkende Elemente. Der Übersicht halber sind nur Bezugszeichen in den einzelnen Zeichnungen dargestellt, die für die Beschreibung der jeweiligen Zeichnung erforderlich sind. Die Größenverhältnisse der einzelnen Elemente zueinander entsprechen dabei nicht immer den realen Größenverhältnissen, da einige Formen vereinfacht und andere Formen zur besseren Veranschaulichung vergrößert im Verhältnis zu anderen Elementen dargestellt sind. Es zeigen in schematischer Darstellung:

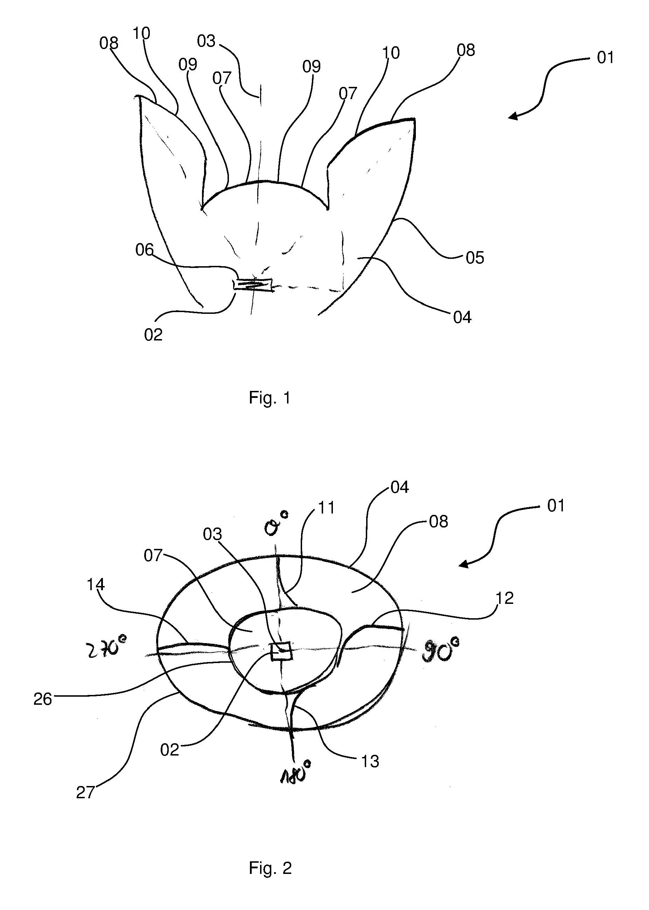

- Fig. 1: einen eine optische Achse einschließenden Querschnitt durch ein erstes Ausführungsbeispiel einer Leuchtdiode mit einem Lichtleitkörper, der in höchstens zwei in unterschiedlichen Winkellagen um die optische Achse herum liegenden und die optische Achse einschließenden Querschnitten eine identische geometrische Formgebung einer ersten, inneren Lichtaustrittsfläche und/oder einer zweiten, äußeren Lichtaustrittsfläche aufweist.
- Fig. 2: eine Draufsicht auf die Lichtaustrittsflächen ein zweites Ausführungsbeispiel einer Leuchtdiode mit einem Lichtleitkörper, der in höchstens zwei in unterschiedlichen Winkellagen um die optische Achse herum liegenden und die optische Achse einschließenden Querschnitten eine identische geometrische Formgebung einer ersten, inneren Lichtaustrittsfläche und/oder einer zweiten, äußeren Lichtaustrittsfläche aufweist, mit in vier unterschiedlichen Winkellagen um die optische Achse herum schematisch angedeuteten Formgebungen der zweiten, äußeren Lichtaustrittsfläche.

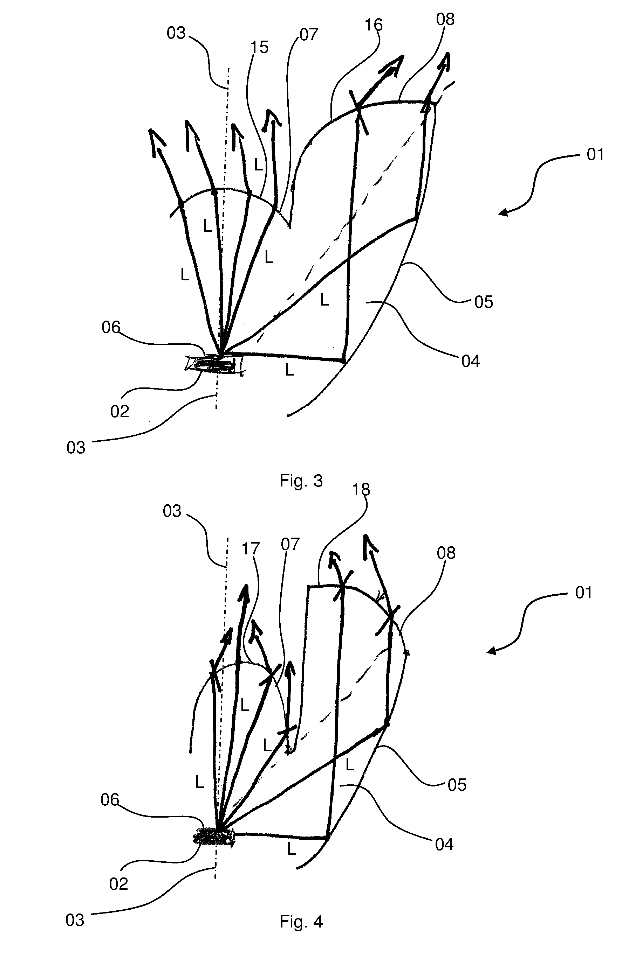

- Fig. 3: eine Teilansicht eines eine optische Achse einschließenden Querschnitts durch ein drittes Ausführungsbeispiel einer Leuchtdiode mit einem Lichtleitkörper, der in höchstens zwei in unterschiedlichen Winkellagen um die optische Achse herum liegenden und die optische Achse einschließenden Querschnitten eine identische geometrische Formgebung einer ersten, inneren Lichtaustrittsfläche und/oder einer zweiten, äußeren Lichtaustrittsfläche aufweist, mit darin schematisch dargestelltem Ausbreitungsweg von durch Pfeile angedeuteten Lichtstrahlen.
- Fig. 4: eine Teilansicht eines eine optische Achse einschließenden Querschnitts durch ein viertes Ausführungsbeispiel einer Leuchtdiode mit einem Lichtleitkörper, der in höchstens zwei in unterschiedlichen Winkellagen um die optische Achse herum liegenden und die optische Achse einschließenden Querschnitten eine identische geometrische Formgebung einer ersten, inneren Lichtaustrittsfläche und/oder einer zweiten, äußeren Lichtaustrittsfläche aufweist, mit darin schematisch dargestelltem Ausbreitungsweg von durch Pfeile angedeuteten Lichtstrahlen.

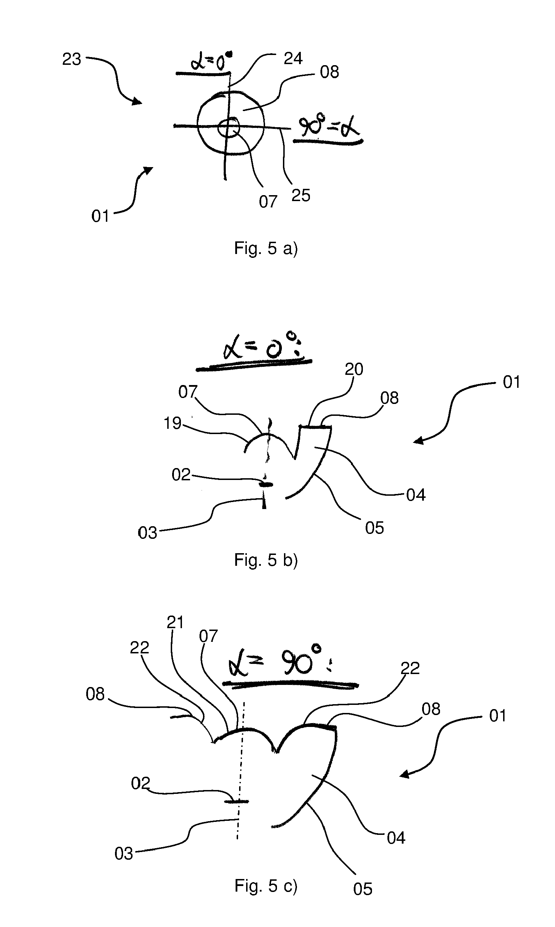

- Fig. 5: ein fünftes Ausführungsbeispiel einer Leuchtdiode mit einem Lichtleitkörper, der in höchstens zwei in unterschiedlichen Winkellagen um die optische Achse herum liegenden und die optische Achse einschließenden Querschnitten eine identische geometrische Formgebung einer ersten, inneren Lichtaustrittsfläche und/oder einer zweiten, äußeren Lichtaustrittsfläche aufweist, wobei:
Fig. 5 a) eine Draufsicht auf die Lichtaustrittsflächen zeigt, welcher Draufsicht die Winkellagen zweier in Fig. 5 b) und Fig. 5 c) dargestellter Querschnitte entnehmbar ist,
Fig. 5 b) eine Teilansicht eines in der in Fig. 5 a) mit 0° bezeichneten Winkellage angeordneten ersten, die optische Achse einschließenden Querschnitts zeigt, und
Fig. 5 c) eine Teilansicht eines in der in Fig. 5 a) mit 90° bezeichneten Winkellage angeordneten zweiten, die optische Achse einschließenden Querschnitts zeigt.

Eine in den Fig. 1 bis Fig. 5 ganz oder in Teilen dargestellte, beispielsweise zur Verwendung in einem Leuchtmittel für eine als Heckleuchte ausgeführte Kraftfahrzeugleuchte vorgesehene Leuchtdiode 01 weist wenigstens einen LED-Chip 02 auf. Eine optische Achse 03 steht auf dem mindestens einen LED-Chip 02 auf.

Die Leuchtdiode 01 umfasst außerdem einen den LED-Chip 02 wenigstens zum Teil umhüllenden Lichtleitkörper 04. Der Lichtleitkörper 04 kann eine zumindest den LED-Chip 02 schützende Kapselung bilden, oder eine solche umfassen, oder Teil einer solchen Kapselung sein. Zumindest der Lichtleitkörper 04 einer solchen Kapselung ist aus einem transparenten, klaren oder eingefärbten, beispielsweise spritzgussgeeigneten Werkstoff, besonders bevorzugt einem Kunststoff hergestellt.

Der Lichtleitkörper 04 weist eine geschlossene Mantelfläche 05 sowie diese von der Oberfläche 06 des LED-Chips 02 entlang der optischen Achse 03 in Richtung der Lichtabstrahlrichtung entfernt abschließend zwei konzentrische Lichtaustrittsflächen 07, 08 auf. Hierbei handelt es sich um eine erste, innere Lichtaustrittsfläche 07 und um eine diese umgebende, zweite, äußere Lichtaustrittsfläche 08.

Die optische Achse 03 kann beispielsweise mittig, vorzugsweise senkrecht auf der Oberfläche 06 des LED-Chips 02 aufstehen.

Von dem LED-Chip 02 abgestrahltes, schematisch vermittels durch Pfeile L dargestellte Lichtstrahlen angedeutetes Licht, trifft entweder direkt auf die erste, innere Lichtaustrittsfläche 07, durch welche es dann aus dem Lichtleitkörper 04 austritt, oder wird wie in Fig. 3 und in Fig. 4 dargestellt unter Totalreflexion zunächst an der Mantelfläche 05 im Lichtleitkörper 04 umgelenkt, bevor es dann auf die zweite, äußere Lichtaustrittsfläche 08 trifft, durch welche es dann aus dem Lichtleitkörper 04 austritt.

Weg vom LED-Chip 02 entlang der optischen Achse 03 ist eine den durch die Pfeile L angedeuteten, vom LED-Chip 02 ausgehenden und aus dem Lichtleitkörper 04 austretenden Lichtstrahlen nach deren Austritt aus dem Lichtleitkörper 04 gemeinsame Lichtabstrahlrichtung der Leuchtdiode 01 definiert.

Der Austritt aus dem Lichtleitkörper 04 durch die erste, innere Lichtaustrittsfläche 07 oder durch die zweite, äußere Lichtaustrittsfläche 08 hindurch erfolgt gegebenenfalls unter Brechung beim Übergang vom Material des Lichtleitkörpers 04 zum diesen umgebenden Medium, typischerweise Luft.

Die innere Lichtaustrittsfläche 07 und/oder die äußere Lichtaustrittsfläche 08 weisen in höchstens zwei in unterschiedlichen Winkellagen um die optische Achse 03 herum liegenden und die optische Achse 03 einschließenden Querschnitten identische geometrische Formgebung auf. In Fig. 1 ist ein solcher, die optische Achse 03 einschließender Querschnitt vollständig und in den Fig. 3, Fig. 4, Fig. 5b) und Fig. 5c) jeweils zum Teil dargestellt.

Hierdurch kann in unterschiedlichen Winkellagen um die optische Achse 03 herum eine Variation der Bündelung und/oder Streuung des Lichts hergestellt werden.

Durch die in höchstens zwei die optische Achse 03 einschließenden Querschnitten identische Formgebung der ersten, inneren Lichtaustrittsfläche 07 und/oder der zweiten, äußeren Lichtaustrittsfläche 08 wird die Variation einer Bündelung und/oder Streuung des aus dem Lichtleitkörper 04 austretenden Lichts abhängig von der Winkellage um die optische Achse 03 herum hergestellt.

Jeder Formgebung der ersten, inneren Lichtaustrittsfläche 07 und/oder der zweiten, äußeren Lichtaustrittsfläche 08 in einem die optische Achse 03 einschließenden Querschnitt entspricht dabei eine Kurve 09, 10, 11, 12, 13, 14, 15, 16, 17, 18, 19, 20, 21, 22, welche den Verlauf der Kontur der ersten, inneren Lichtaustrittsfläche 07 und/oder der zweiten, äußeren Lichtaustrittsfläche 08 in einer die optische Achse 03 einschließenden Ebene beschreibt.

Die die Formgebung der ersten, inneren Lichtaustrittsfläche 07 beschreibende Kurve 09, 15, 17, 19, 21 und die die Formgebung der zweiten, äußeren Lichtaustrittsfläche 08 beschreibende Kurve 10, 11, 12, 13, 14, 16, 18, 20, 22 können dabei stetig oder unstetig und/oder stetig oder unstetig differenzierbar ineinander übergehen.

In Fig. 2 sind für unterschiedliche Winkellagen um die optische Achse 03 herum unterschiedliche Formgebungen der zweiten, äußeren Lichtaustrittsfläche 08 beschreibende Kurven 11, 12, 13, 14 angedeutet. Die Kurvenverläufe sind hierbei in der schematischen Darstellung in die Betrachtungsebene gedreht, so dass sie in der Draufsicht erkennbar sind.

Die Lichtabstrahlcharakteristik der Leuchtdiode 01 ist durch eine winkellagenabhängig hergestellte Bündelung oder Streuung hin oder weg von der optischen Achse 03 eingestellt. Dabei wird durch eine Formgebung der ersten, inneren Lichtaustrittsfläche 07 und/oder der zweiten, äußeren Lichtaustrittsfläche 08 jeden zwei um 180° versetzte Winkellagen einschließenden Querschnitts für jede Winkellage ein Bereich eines Abstrahlwinkels festgelegt, innerhalb dem von dem LED-Chip 02 ausgestrahltes Licht aus dem Lichtleitkörper 04 austritt.

Dem entspricht eine Schaar von aus dem Lichtleitkörper 04 austretender Lichtstrahlen innerhalb der jeweiligen durch den die entsprechenden, um 180° versetzten Winkellagen umfassenden Querschnitt festgelegten, die optische Achse 03 einschließenden Ebene.

Es können beispielsweise höchstens zwei die optische Achse 03 einschließende Querschnitte jeweils identische Formgebungen der ersten, inneren Lichtabstrahlfläche 07 aufweisen. Hierdurch weist die erste, innere Lichtabstrahlfläche 07 eine elliptische oder rechteckige Lichtabstrahlcharakteristik auf, welche deutlich von einer radialsymmetrischen Lichtabstrahlcharakteristik abweicht.

Alternativ oder zusätzlich können beispielsweise höchstens zwei die optische Achse 03 einschließende Querschnitte jeweils identische Formgebungen der zweiten, äußeren Lichtabstrahlfläche 08 aufweisen. Hierdurch wird für die zweite, äußere Lichtabstrahlfläche 08 eine elliptische oder rechteckige Lichtabstrahlcharakteristik erhalten, welche ebenfalls deutlich von einer radialsymmetrischen Lichtabstrahlcharakteristik abweicht.

Die Lichtleitkörper 04 können wie in Fig. 1 dargestellt und wie in Fig. 5 c) angedeutet eine symmetrische, geometrische Formgebung sowohl der ersten, inneren Lichtabstrahlfläche 07, als auch der zweiten, äußeren Lichtabstrahlfläche 08 in mindestens einem die optische Achse 03 einschließenden Querschnitt aufweisen. Die Symmetrie bezieht sich hierbei jeweils auf die in einem die optische Achse 03 einschließenden Querschnitt enthaltenen, um 180° zueinander versetzten Winkellagen der jeweiligen Lichtaustrittsfläche 07, 08. Es kann demnach vorgesehen sein, dass in dem Querschnitt beispielsweise nur die Kurven 09, 15, 17, 19, 21 der Formgebung der in einem Querschnitt enthaltenen, um 180° zueinander versetzten Winkellagen der ersten, innere Lichtaustrittsfläche 07 symmetrisch zur optischen Achse 03 ist, wohingegen die Kurven 11, 12, 13, 14, 16, 18, 20 der Formgebung der zweiten, äußeren Lichtaustrittsfläche 08 in den beiden in dem Querschnitt enthaltenen, um 180° zueinander versetzten Winkellagen keine Symmetrie zur optischen Achse 03 aufweisen. Auch ist eine umgekehrte Ausgestaltung denkbar, oder wie bereits erwähnt eine symmetrische Ausgestaltung sowohl der ersten, inneren Lichtabstrahlfläche 07, als auch der zweiten, äußeren Lichtabstrahlfläche 08 in mindestens einem die optische Achse 03 einschließenden Querschnitt.

In Fig. 5 a) ist eine der Projektion der ersten, inneren Lichtaustrittsfläche 07 und der zweiten, äußeren Lichtaustrittsfläche 08 auf eine normal zur optischen Achse 03 liegende Fläche entlang der Lichtabstrahlrichtung gesehen entsprechende Draufsicht auf einen Lichtleitkörper 04 einer Leuchtdiode 01 dargestellt. Fig. 5 zeigt in dieser Draufsicht auf den Lichtleitkörper 04 ein gedachtes, im Urzeigersinn drehendes kartesisches Koordinatensystem 23, in welchem die positive Ordinatenachse 24 einer 0°-Winkellage und die positive Abszissenachse 25 einer 90°-Winkellage entspricht. Sowohl die Ordinatenachse 24, als auch die Abszissenachse 25 verlaufen dabei normal zur optischen Achse 03. Der 0°-Winkellage entspricht der in Fig. 5 b) dargestellte rechte Teil eines die um 180° versetzte 180° Winkellage sowie die optische Achse 03 einschließenden Querschnitts. Der 90°-Winkellage entspricht der in Fig. 5 c) dargestellte rechte Teil eines die um 180° versetzte 270°-Winkellage sowie die optische Achse 03 einschließenden Querschnitts.

Um einen Lichtleitkörper 04 einer Leuchtdiode mit einer ausgeprägt elliptischen oder rechteckigen Lichtabstrahlcharakteristik, bei der eine erste Ausdehnung eine zweite Ausdehnung deutlich übersteigt, zu erhalten, sind die durch die Kurve 19 beschriebene geometrische Formgebung der ersten, inneren Lichtabstrahlfläche 07 und die durch die Kurve 20 beschriebene geometrische Formgebung der zweiten, äußeren Lichtabstrahlfläche 08 im in Fig. 5 b) dargestellten, die optische Achse 03 einschließenden Querschnitt der 0°-Winkellage (sowie gedacht der von diesem Querschnitt umfassten, um 180° zur optischen Achse 03 versetzten 180°-Winkellage) so gewählt, dass das Licht beim Austritt aus dem Lichtleitkörper in dieser Winkellage entlang der optischen Achse 03 gebrochen wird.

Die durch die Kurve 21 beschriebene geometrische Formgebung der ersten, inneren Lichtabstrahlfläche 07 und die durch die Kurve 22 beschriebene geometrische Formgebung der zweiten, äußeren Lichtabstrahlfläche 08 im in Fig. 5 c) dargestellten, die optische Achse 03 einschließenden Querschnitt der 90°-Winkellage (sowie gedacht der von diesem Querschnitt umfassten, um 180° zur optischen Achse 03 versetzten 270°-Winkellage) hingegen sind so gewählt, dass das Licht beim Austritt aus dem Lichtleitkörper in dieser Winkellage unter einem eingeschlossenen Winkel von beispielsweise bis zu ± 20° zur optischen Achse 03 gebrochen wird. Auch ist denkbar, in einer zweiten Winkellage wie der beispielhaft beschriebenen 90°-Winkellage einen Abstrahlwinkel entsprechend einem Austritt aus dem Lichtleitkörper 04 unter einem eingeschlossenen Winkel zur optischen Achse 03 zwischen 20° und 40° zu verwirklichen. Grundsätzlich kann in jedem Querschnitt einer Winkellage ein zur Herstellung einer gewünschten Lichtabstrahlcharakteristik erforderlicher Abstrahlwinkel verwirklicht werden. Dabei können für jede Winkellage unterschiedliche Abstrahlwinkel vorgesehen sein.

Im in Fig. 5 dargestellten Ausführungsbeispiel markieren die 0°-Winkellage und die 180°-Winkellage die Richtung einer deutlich geringeren Ausdehnung der Lichtabstrahlcharakteristik, wohingegen die 90°-Winkellage und die 270°-Winkellage die Richtung der deutlich größeren Ausdehnung der Lichtabstrahlcharakteristik markieren.

Wichtig ist hervorzuheben, dass die Formgebungen der ersten, inneren Lichtaustrittsfläche 07 und/oder der zweiten, äußeren Lichtaustrittsfläche beispielsweise in Winkellagen bei 0° und bei 180° um die optische Achse 03 herum, in einem diese beiden Winkellagen umfassenden, die optische Achse 03 einschließenden Querschnitt die selben Kurven 09, 10, 15, 17, 19, 21, 22 besitzen können, um in diesen Winkellagen die selben Abstrahlwinkel zu gewährleisten.

Dabei ist grundsätzlich auch bei 90° und 270° oder bei anderen, um 180° um die optische Achse 03 versetzten Winkellagen denkbar, ein Paar identische Kurven 09, 10, 15, 17, 19, 21, 22 für die Formgebung der ersten, inneren Lichtaustrittsfläche 07 und/oder der zweiten, äußeren Lichtaustrittsfläche 08 vorzusehen, um ebenso identische Abstrahlwinkel zu gewährleisten.

Zur Variation der Abstrahlwinkel kann die erste, innere Lichtaustrittsfläche 07 in einem die optische Achse 03 einschließenden Querschnitt betrachtet zumindest abschnittsweise eine geometrische Formgebung entsprechend einer Kurve 09, 15, 17, 19, 21 mit einer konvexen Wölbung aufweisen.

Die zweite, äußere Lichtaustrittsfläche 08 kann in einem die optische Achse 03 einschließenden Querschnitt betrachtet zumindest abschnittsweise eine geometrische Formgebung entsprechend einer Kurve 10, 11, 12, 13, 16, 22 mit einer zur ersten, inneren Lichtaustrittsfläche 07 hin abfallenden Wölbung aufweisen, um unterschiedliche Abstrahlwinkel herzustellen.

Eine zusätzliche Variationsmöglichkeit ergibt sich, indem die zweite, äußere Lichtaustrittsfläche 08 zumindest abschnittsweise eine geometrische Formgebung entsprechend einer Kurve 18 mit einer in einem die optische Achse 03 einschließenden Querschnitt betrachtet von der ersten, inneren Lichtaustrittsfläche 07 weg und zur Mantelfläche 05 hin abfallenden Wölbung aufweist.

Eine weitere Variationsmöglichkeit ergibt sich, indem die zweite, äußere Lichtaustrittsfläche 08 zumindest abschnittsweise eine geometrische Formgebung entsprechend einer Kurve 20 entlang einer in einem die optische Achse 03 einschließenden Querschnitt betrachtet normal zur optischen Achse 03 verlaufenden Geraden aufweist.

Entlang der optischen Achse 03 in Richtung der Lichtabstrahlrichtung gesehen kann die zweite, äußere Lichtaustrittsfläche 08 die erste, innere Lichtaustrittsfläche 07 überragen. Hierdurch ergibt sich eine zusätzliche Variationsmöglichkeit und die Möglichkeit der Anpassung an bestimmte Bauraumsituationent.

In einer Projektion auf eine normal zur optischen Achse 03 liegende Fläche entlang der Lichtabstrahlrichtung gesehen kann die erste, innere Lichtaustrittsfläche 07 eine der Lichtabstrahlcharakteristik der Leuchtdiode 01 entsprechende, elliptische oder rechteckige Außenkontur 26 aufweisen. Alternativ oder zusätzlich kann die zweite, äußere Lichtaustrittsfläche 08 eine der Lichtabstrahlcharakteristik der Leuchtdiode 01 entsprechende, elliptische oder rechteckige Außenkontur 27 aufweisen.

Durch die genannten Maßnahmen wird eine Leuchtdiode 01 geschaffen, welche eine für einen Anwendungsfall gezielt hergestellte, beispielsweise elliptische oder rechteckige Lichtabstrahlcharakteristik aufweist. Eine solche elliptisch oder rechteckig abstrahlende Leuchtdiode ist zur Behebung der Eingangs erwähnten Nachteile des Standes der Technik ideal, da diese so hergestellt werden kann, dass sie in horizontaler Richtung in gewünschtem Winkelbereicht streut und in vertikaler Richtung wenig Lichtleistung emittiert oder nur in einem geringen Winkelbereich emittiert.

Weitere Vorteile ergeben sich durch den Verzicht auf aufwändige Kissenoptiken und große optische Körper, welche aufgrund der geringen optischen Toleranzen entweder sehr aufwändig und damit teuer in der Entwicklung, Werkzeugherstellung sind, oder da ein großer optischer Körper hergestellt werden muss aufgrund einer langen Zykluszeit in der Produktion teuer sind.

Die Erfindung ist insbesondere im Bereich der Herstellung von Leuchtdioden als Lichtquellen für Beleuchtungszwecke sowie für Kraftfahrzeugleuchten gewerblich anwendbar.

### Bezugszeichenliste

- 01: Leuchtdiode
- 02: LED-Chip
- 03: optische Achse
- 04: Lichtleitkörper
- 05: Mantelfläche
- 06: Oberfläche des LED-Chips
- 07: erste Lichtaustrittsfläche
- 08: zweite Lichtaustrittsfläche
- 09: Kurve
- 10: Kurve
- 11: Kurve
- 12: Kurve
- 13: Kurve
- 14: Kurve
- 15: Kurve
- 16: Kurve
- 17: Kurve
- 18: Kurve
- 19: Kurve
- 20: Kurve
- 21: Kurve
- 22: Kurve
- 23: Koordinatensystem
- 24: positive Ordinatenachse
- 25: positive Abszissenachse
- 26: Außenkontur
- 27: Außenkontur

## Patentansprüche

1. Leuchtdiode (01) mit:
- mindestens einem LED-Chip (02),
- einer auf dem mindestens einen LED-Chip (02) aufstehenden optischen Achse (03),
- einer Lichtabstrahlrichtung entlang der optischen Achse (03) weg von dem mindestens einen LED-Chip (02), und
- einem den LED-Chip (02) wenigstens zum Teil umhüllenden Lichtleitkörper (04), der eine geschlossene Mantelfläche (05) sowie diese von der Oberfläche (06) des LED-Chips (02) entlang der optischen Achse (03) in Richtung der Lichtabstrahlrichtung entfernt abschließend zwei konzentrische Lichtaustrittsflächen (07, 08) aufweist, eine erste Lichtaustrittsfläche (07) und eine diese umgebende, zweite Lichtaustrittsfläche (08),
wobei von dem LED-Chip (02) abgestrahltes Licht zum Austritt aus dem Lichtleitkörper (04) entweder direkt auf die erste Lichtaustrittsfläche (07) trifft, oder unter Totalreflexion zunächst an der Mantelfläche (05) im Lichtleitkörper (04) umgelenkt wird, bevor es dann auf die zweite Lichtaustrittsfläche (08) trifft, **gekennzeichnet durch**
höchstens zwei in unterschiedlichen Winkellagen um die optische Achse (03) liegende und die optische Achse (03) einschließende Querschnitte mit identischer geometrischer Formgebung (09, 10, 15, 17, 19, 21, 22) der inneren und/oder der äußeren Lichtaustrittsflächen (07, 08).

2. Leuchtdiode nach Anspruch 1,
**dadurch gekennzeichnet,**
**dass** höchstens zwei die optische Achse (03) einschließende Querschnitte jeweils identische Formgebungen (09, 15, 17, 19, 21) der ersten Lichtabstrahlfläche (07) aufweisen.

3. Leuchtdiode nach Anspruch 1 oder 2,
**dadurch gekennzeichnet,**
**dass** höchstens zwei die optische Achse (03) einschließende Querschnitte jeweils identische Formgebungen (10, 22) der zweiten Lichtabstrahlfläche (08) aufweisen.

4. Leuchtdiode nach Anspruch 1, 2 oder 3,
**dadurch gekennzeichnet,**
**dass** der Lichtleitkörper (04) angespritzt ist.

5. Leuchtdiode nach einem der Ansprüche 1 bis 4,
**dadurch gekennzeichnet,**
**dass** die optische Achse (03) mittig und/oder senkrecht auf der Oberfläche (06) des mindestens einen LED-Chips (02) aufsteht.

6. Leuchtdiode nach einem der vorhergehenden Ansprüche,
**dadurch gekennzeichnet**
**dass** der Austritt aus dem Lichtleitkörper (04) durch die erste Lichtaustrittsfläche (07) und/oder durch die zweite Lichtaustrittsfläche (08) hindurch zumindest zum Teil unter Brechung beim Übergang vom Material des Lichtleitkörpers (04) zum diesen umgebenden Medium erfolgt.

7. Leuchtdiode nach einem der vorhergehenden Ansprüche,
**dadurch gekennzeichnet,**
**dass** die erste Lichtaustrittsfläche (07) in einem die optische Achse (03) einschließenden Querschnitt betrachtet zumindest abschnittsweise eine geometrische Formgebung entsprechend einer Kurve (09, 15, 17, 19, 21) mit einer konvexen Wölbung aufweist.

8. Leuchtdiode nach einem der vorhergehenden Ansprüche,
**dadurch gekennzeichnet,**
**dass** die zweite Lichtaustrittsfläche (08) zumindest abschnittsweise eine geometrische Formgebung entsprechend einer Kurve (10, 11, 12, 13, 16, 22) mit einer in einem die optische Achse (03) einschließenden Querschnitt betrachtet zur ersten Lichtaustrittsfläche (07) hin abfallenden Wölbung aufweist.

9. Leuchtdiode nach einem der vorhergehenden Ansprüche,
**dadurch gekennzeichnet,**
**dass** die zweite Lichtaustrittsfläche (08) zumindest abschnittsweise eine geometrische Formgebung entsprechend einer Kurve (18) mit einer in einem die optische Achse (03) einschließenden Querschnitt betrachtet von der ersten Lichtaustrittsfläche (07) weg und zur Mantelfläche (05) hin abfallenden Wölbung aufweist.

10. Leuchtdiode nach einem der vorhergehenden Ansprüche,
**dadurch gekennzeichnet,**
**dass** die zweite Lichtaustrittsfläche (08) zumindest abschnittsweise eine geometrische Formgebung entsprechend einer in einem die optische Achse (03) einschließenden Querschnitt betrachtet normal zur optischen Achse (03) verlaufenden Geraden (20) aufweist.

11. Leuchtdiode nach einem der vorhergehenden Ansprüche,
**dadurch gekennzeichnet,**
**dass** entlang der optischen Achse (03) in Richtung der Lichtabstrahlrichtung gesehen die zweite Lichtaustrittsfläche (08) die erste Lichtaustrittsfläche (07) überragt.

12. Leuchtdiode nach einem der vorhergehenden Ansprüche,
**dadurch gekennzeichnet,**
**dass** in einer Projektion auf eine normal zur optischen Achse (03) liegende Fläche die erste Lichtaustrittsfläche (07) und/oder die zweite Lichtaustrittsfläche (08) eine elliptische Außenkontur (26, 27) aufweisen.

13. Leuchtdiode nach einem der vorhergehenden Ansprüche,
**gekennzeichnet durch**
eine symmetrische, geometrische Formgebung sowohl der ersten Lichtabstrahlfläche (07), als auch der zweiten Lichtabstrahlfläche (08) in mindestens einem die optische Achse (03) einschließenden Querschnitt.
